Europäisches Patentamt

European Patent Office

Office européen des brevets

(11) Publication number: **0 101 318**

**B1**

(12) **EUROPEAN PATENT SPECIFICATION**

(45) Date of publication of patent specification: **28.10.87**

(21) Application number: **83304727.7**

(22) Date of filing: **15.08.83**

(51) Int. Cl.⁴: **G 06 F 7/544,** H 03 H 17/06, G 06 F 7/48

(54) **Digital filters.**

(30) Priority: **17.08.82 JP 142527/82**

(43) Date of publication of application:
**22.02.84 Bulletin 84/08**

(45) Publication of the grant of the patent:
**28.10.87 Bulletin 87/44**

(84) Designated Contracting States:
**AT DE FR GB NL**

(56) References cited:
**EP-A-0 014 151**
**FR-A-2 441 214**

**THE RADIO AND ELECTRONIC ENGINEER, vol.
45, no. 3, March 1975, LONDON (GB) P.M.
THOMPSON et al.: "Digital arithmetic units for
a high data rate", pages 116-120.
Idem.
COMPUTER DESIGN, vol. 19, no. 3, March
1980, CONCORD (US), W.J. FINN: "LSI
hardware implements signal processing
algorithms", pages 137-142.
Idem.**

(73) Proprietor: **SONY CORPORATION
7-35 Kitashinagawa 6-Chome Shinagawa-ku
Tokyo 141 (JP)**

(72) Inventor: **Iwase, Seiichiro c/o Patent Division
Sony Corporation 7-35 Kitashinagawa 6-chome
Shinagawa-ku Tokyo (JP)**

(74) Representative: **Thomas, Christopher Hugo
et al
D Young & Co 10 Staple Inn
London WC1V 7RD (GB)**

Courier Press, Leamington Spa, England.

## Description

This invention relates to digital filters.

It has been a matter of some difficulty to provide, at reasonable cost, digital filters capable of operating at the required speed. This is because such filters have used high-speed logic elements such as TTL (transistor-transistor logic) or ECL (emitter-coupled logic) and adder circuits using carry look-ahead circuits, which are expensive.

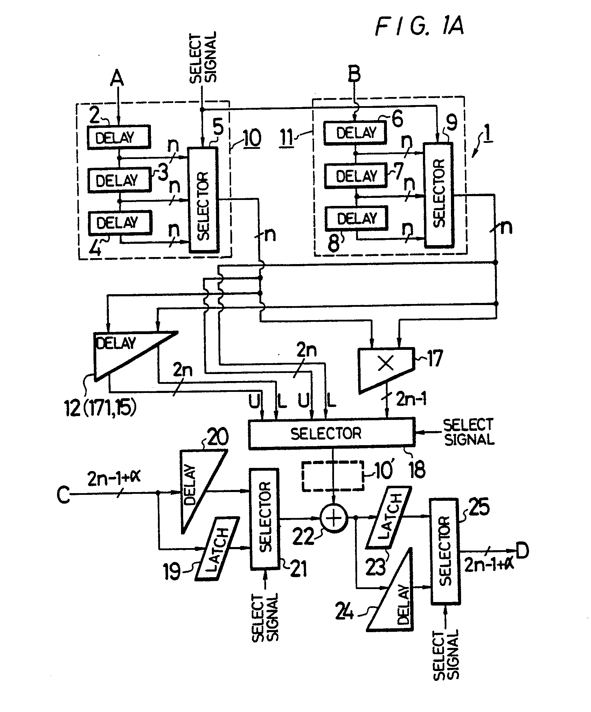

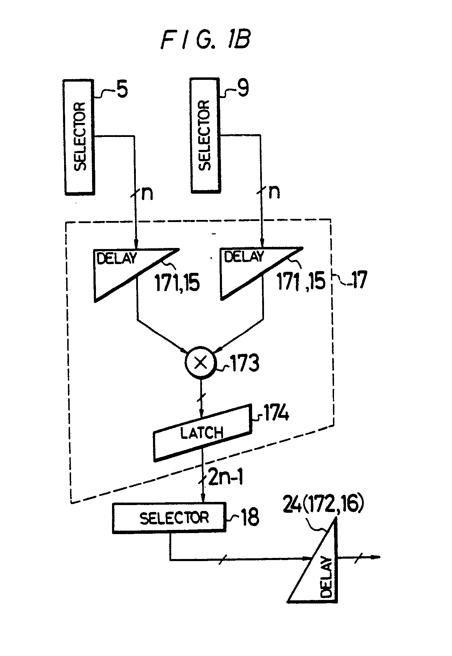

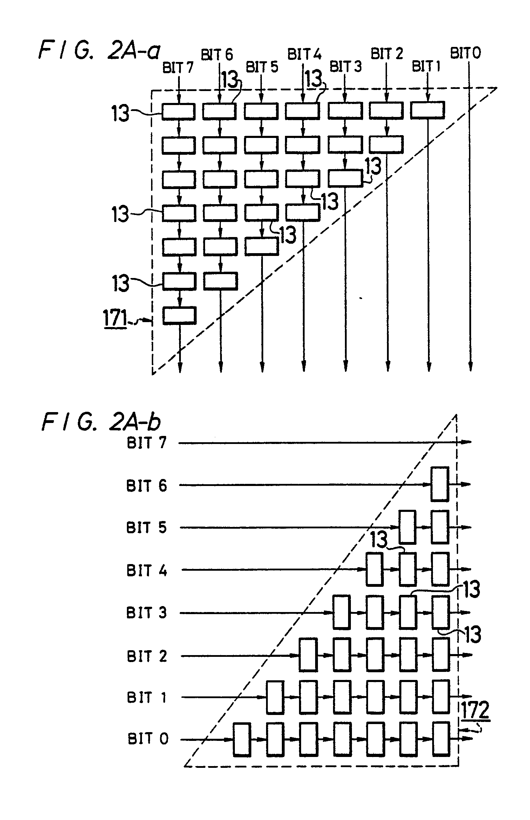

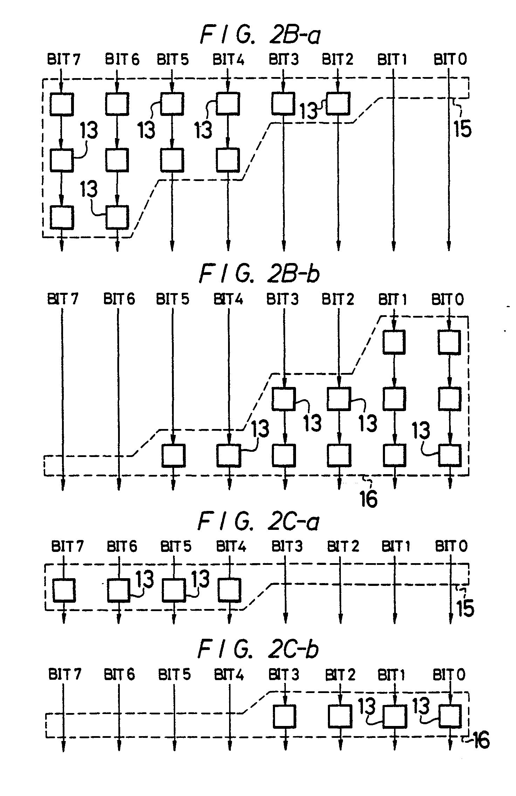

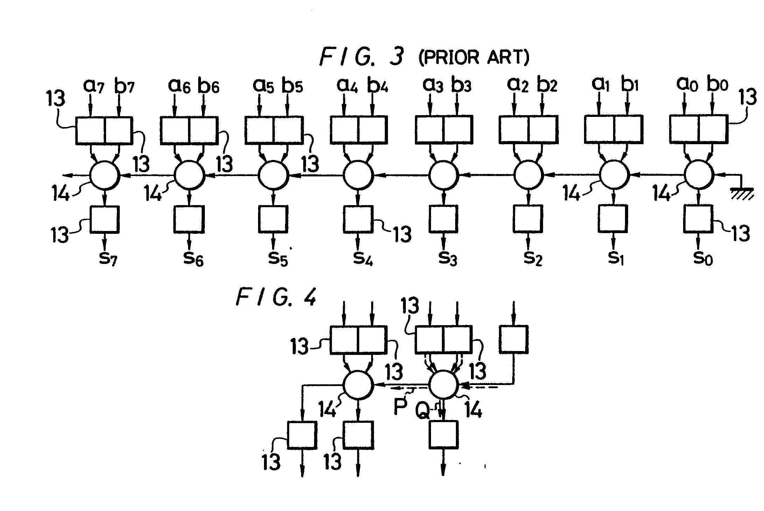

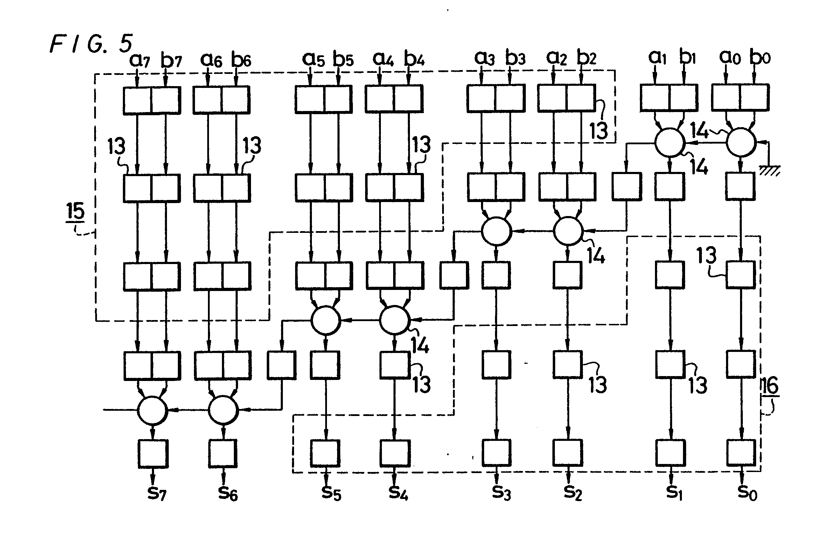

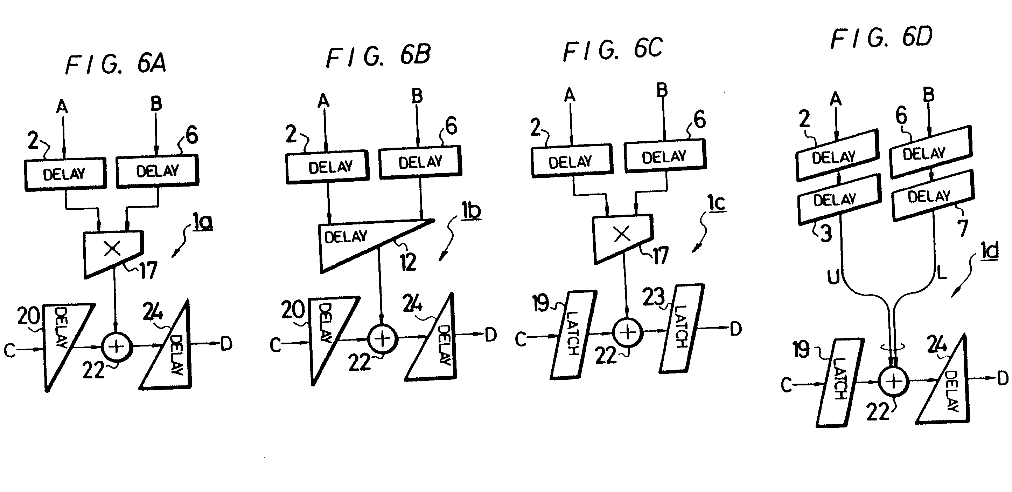

In 'The Radio and Electronic Engineer', Volume 45, No. 3, March 1975, pages 116 to 120, there is disclosed in Section 3 a so-called diagonally timed adder (shown in Figures 2 and 3 on page 117 thereof) suitable for adding two digital signals, and in Section 4 so-called diagonally timed multipliers (shown in Figures 4 and 5 on pages 118 and 119 thereof) and accumulators (shown in Figure 6 on page 119 thereof). In European patent specification EP—A1—0 014 151 there is disclosed a multi-stage digital filter comprising a plurality of cascaded stages including respective digital processing circuits each comprising a multiplier for multiplying signals of a plurality of bits by each other to produce a product signal (see in particular Figure 1 and the corresponding description).

According to the present invention there is provided a multi-stage digital filter comprising:

a plurality of stages including respective digital signal processing circuits each comprising a multiplier means for multiplying signals of a plurality of bits by each other to produce a product signal; characterized by:

each of said digital signal processing circuits further comprising summand signal delay circuit means for delaying each bit signal of a summand signal of a plurality of bits by a unit delay, adder means for adding said product signal from said multiplier means to the summand signal from said summand signal delay circuit means, and sum signal delay circuit means for delaying each bit signal of the sum signal from said adder means by a unit delay, said multiplier means, said summand signal delay circuit means, said adder means and said sum signal delay circuit means being formed in the same semiconductor chip;

odd-stage cascade circuit means formed of said digital signal processing circuits of odd stages being connected in cascade so that an output signal of a first-stage digital signal processing circuit is supplied to a third-state digital signal processing circuit as said summand signal;

even-stage cascade circuit means formed of said digital signal processing circuits of even stages being connected in cascade so that an output signal of a second-stage digital signal processing circuit is supplied to a fourth-stage digital signal processing circuit as said summand signal;

adder means for adding output signals from said odd-stage cascade circuit means and said even-stage cascade circuit means together in such a manner that said output signals are given an equal delay; and

output circuit means for delaying an output signals from said adder means which adds the output signal from said even-stage and odd-stage cascade circuit means.

The invention will now be described by way of example with reference to the accompanying drawings, throughout which like parts are referred to by like references, and in which:

Figure 1A is a block diagram showing a basic digital signal processing circuit;

Figure 1B is a block diagram showing an example of a multiplier section used in the digital signal processing circuit of Figure 1A;

Figures 2A-a to 2C-b are respectively block diagrams showing examples of delay circuits used in the digital signal processing circuit of Figure 1A;

Figure 3 is a block diagram showing an example of a prior art adding circuit;

Figure 4 is a block diagram showing an example of a fundamental 2-bit full adder circuit forming a calculating circuit used in a digital signal processing circuit;

Figure 5 is a block diagram showing an example of a calculator having the 2-bit full adder block shown in Figure 4 as a calculator unit;

Figures 6A to 6D are block diagrams showing circuits for a digital signal processing circuit;

Figure 7A is a block diagram showing an embodiment of digital filter according to the invention realised by the combination of a plurality of digital signal processing circuits; and

Figure 7B is a block diagram showing an equivalent circuit thereof.

Figure 1A is a block diagram showing a basic digital signal processing circuit 1 used in embodiments of the invention and comprising delay circuits 2, 3 and 4 connected in cascade, each of which delays a multiplicand signal A of n bits by a unit delay amount. A selector 5 receives the output signals of the delay circuits 2, 3 and 4 and selectively supplies one of those output signals as specified by a select signal supplied thereto. Further delay circuits 6, 7 and 8 are connected in cascade, and each delays a multiplier signal B of n bits by a unit delay amount. A selector 9 receives the output signals of the delay circuits 6, 7 and 8 and selectively supplies one of those output signals as specified by the select signal supplied thereto. The delay circuits, 2, 3 and 4 and the selector 5, and the delay circuits 6, 7 and 8 and the selector 9 form respective variable delay circuits 10 and 11, each of which delays the respective bit signals of the multiplicand and multiplier signals A and B by a proper delay amount. Thus, the multiplicand signal A and the multiplier signal B supplied thereto can be delayed by one to three times the unit delay amount by the select signal which controls the selectors 5 and 9. As an alternative to the variable delay circuits 10 and 11 in the signal paths of the multiplicand signal A and the multiplier signal B respectively, a delay circuit 10' (shown by a broken line block in Figure 1A) of large delay amount can be connected to the output side of a selector 18, which will be described later.

Figure 1B shows one example of the circuit configuration of a multiplier section 17 shown in Figure 1A and described later. Other configurations are possible. In Figure 1B, the circuit comprises respective delay circuits 171 for the multiplicand signal and for the multiplier signal. Each of the delay circuits 171 functions to delay a digital signal supplied thereto in such a manner that more significant bits are given progressively larger unit delays.

Figure 2A-a is a block diagram showing a first example of each of the delay circuits 171 in which delay elements 13 form the delay circuit 171. The delay circuit 171 is so formed that it delays a digital signal of bit 0 by zero, a signal of bit 1 by a unit delay amount, a signal of bit 2 by twice the unit delay amount and so on. Thus more significant bits are delayed by progressively larger unit delay amounts. The reason why the more significant bits of the digital signal formed of a plurality of bits are given a larger delay is that a multiplier section and an adder section, which will be described later, can then be formed of low-speed logic elements.

Turning back to Figure 1B, a multiplier section 173 multiplies the multiplicand signal A and the multiplier signal B supplied by the two delay circuits 171 with each other. Thus, the multiplier 173 generates therefrom a product signal $A \cdot B$ in the order from the least significant bit to the most significant bit. A delay or latch circuit 174 delays the respective bit signals of the product signal $A \cdot B$ by a unit delay amount. Instead of the delay circuits 171, a delay circuit 15 as shown by a broken line in Figures 2B-a and 2C-a which will be described below can be used. The digital signal processing circuit will now be described more fully with reference to Figure 1A.

In Figure 1A, a delay circuit 12 receives the multiplier signal B as its less significant bit signal and the multiplicand signal A as its more significant bit signal, and delays a signal of 2n bits formed of the multiplicand signal A and the multiplier signal B in such a way that the more significant bits are given a progressively larger delay. The delay circuit 12 is the same as the delay circuits 171 of n bits with only the difference that the bit number thereof is $2n - 1$.

In a digital colour video camera circuit, for example, it is usual for a calculator for adding or multiplying data of, for example, 8 bits with each other to be formed of quite high-speed logic elements such as TTL (transistor-transistor logic) or ECL (emitter-coupled logic). The reason for this is as follows. When signals of a plurality of bits are added to each other, it is necessary that the least significant bits are used first in the calculation, and after the presence or absence of the carry bit has been decided, the immediately more significant bits are used. In other words, the calculation using the less significant bits must be followed by the calculation using the more significant bits, so that, in order to complete the calculation quickly, high-speed logic elements are required to prevent the transmission delay time from being increased.

Figure 3 is a block diagram showing an example of a conventional 8-bit ripple-carry adder circuit. The circuit comprises one-bit flip-flops 13 and one-bit full adders 14. In each of the full adders 14, the two inputs from above denote adding inputs, the output downwards represents the added output, the input from the right-hand side represents the carry input and the output to the left-hand side represents the carry output to the more significant bits. Of course, in this case, if a calculator having a so-called carry look-ahead circuit is employed, all the bits can be calculated at high speed. In this case, however, even although the expensive carry look-ahead circuit must be provided, its operational speed is limited by the carry transmission speed.

Therefore, the delay circuit shown in Figure 2A-a is used to delay the added inputs in such a manner that more significant bits are given progressively larger delays. Thus, each data bit, which was converted to digital form by sampling at the same time, can be calculated at the processing speed of one bit per one period of a clock pulse. Moreover, the one-bit flip-flop circuit 13 is connected to the carry transmission path between the full adders 14 in Figure 3. The signal derived from the calculator in the sequential order of less significant bits to more significant bits each time the unit delay time elapses is delayed by the delay circuits shown in Figure 2A-b in such a way that a less significant bit is given a larger unit delay amount increasing progressively bit by bit. As a result, all the bit signals of the data, which were sampled at the same sampling time, can be supplied therefrom at the same time. Thus, the data originally generated during the sampling period at the same time can be processed by the calculator at a very slow processing speed of one bit per one period of the clock pulse. This, however, causes a defect that the number of the delay elements 13 in the delay circuits, which are provided at the input and output sides of the calculator, must be substantially increased. In this connection, each of the delay circuits 171 shown in Figures 2A-a and 2A-b, for example, uses twenty-eight delay elements 13, so that the number delay elements 13 required becomes substantial.

In connection with the adder circuit employing the delay circuit 171 shown in Figures 2A-a and 2A-b, we have filed UK Patent Application No. 8303532 on 9 February 1983.

An alternative basic digital signal processing circuit used in embodiments of the invention employs a full adder block of a plurality of bits, for example, two bits as shown in Figure 4, as a construction unit of a calculator. The calculator having the above full adder blocks of two bits is as shown in Figure 5. Although such a calculator requires delay circuits 15 and 16, each of which is formed of flip-flops 13, the operational speed thereof is high, as compared with the conventional calculator shown in Figure 3.

As compared with the delay circuits in the circuits shown in Figures 2A-a and 2A-b which are required when the calculated signal is delayed and then calculated in such a manner that more significant bits are given progressively larger unit delays, it is possible to decrease the number of delay elements such as the flip-flops 13 required for the delay circuits, for example, the delay circuits 15 and 16. In other words, in this alternative circuit, without necessarily increasing the number of delay elements in the delay circuits, a high-speed calculator can be provided. Moreover, in this alternative circuit, the delay amount for the number of bits of each full adder block taken as a construction unit of the calculator is not limited to every two bits, four bits and so on as an example. As compared with a transmission delay time necessary for the added result of the one-bit full adder in Figure 4 (the transmission time in the direction shown by an arrow Q), a transmission delay time necessary for the carry output of the one-bit full adder (the transmission time in the direction shown by an arrow P) is in general short. Thus, the delay amount for the number of bits of the calculation blocks in Figures 2B-a and 2B-c must be selected as an optimum to make these predetermined times substantially equal to each other. In consequence, the number of latches or delay circuits 13 can be reduced and also the calculation speed thereof can be made as high as possible.

Accordingly, even if the digital signal processing circuit 1 is formed of a low-speed logic element, such as complementary metal oxide semiconductor element, the processing speed thereof can be increased and the number of logic elements used therein can be reduced.

Because such a calculator is employed in the digital signal processing circuit 1, the calculator requires at its input side the delay circuit 171 or 15 by which a digital signal is delayed such that more significant bits are given a larger delay. That is, when the delay circuit 171 is employed in the multiplier section 17, the delay circuit 12 shown in Figure 1A receives the multiplier signal B as a signal of less significant bits and the multiplicand signal A as a signal of more significant bits and delays one signal of 2n bit signals formed of the multiplicand signal A and the multiplier signal B in such a manner that its more significant bits are given a larger delay. Moreover, when the delay circuit 15 shown in Figure 5 is provided in the multiplier 17, it is necessary to use as the delay circuit 12 a delay circuit 15 shown in Figure 2B-a, or in some cases shown in Figure 2C-a, which delays the bits by amounts which increase at intervals of every two or four bits of the calculator blocks. In Figure 2B-a and 2C-a, the fact that the delay is different in amount for each bit is indicated by the slant lines at the output or input side of the circuit block shown by a broken line. The delay circuits shown in Figures 2B-a and 2C-a will be described more fully with reference to Figure 1A. The delay circuit 12 in Figure 1A receives the multiplier signal B as a signal of less significant bits and the multiplicand signal A as a signal of more significant bits and delays one signal of 2n bit signals formed of the multiplicand signal A and the multiplier signal B in such a manner that more significant bits are given a larger delay. If, for example, n = 4 and the one-bit flip-flop is represented as reference numeral 13, the delay circuit 12 is constructed as shown in Figure 2B-a or Figure 2C-a, and operates to delay the input signal of eight bits at intervals of a plurality of bits, for example, two or four bits in such a manner that more significant bits are given a larger delay.

The multiplier section 17 having the delay circuit 15 instead of the delay circuit 171 will now be described.

In Figure 1B, reference numeral 17 represents the multiplier section (as described above, the delay circuit 15 thereof is different in construction from that of the multiplier section shown by reference numeral 171) which multiplies the multiplicand signal A and the multiplier signal B supplied from the selectors 5 and 9 with each other. This multiplier section 17 is formed of the delay circuit 15 and adder circuits 14 shown in Figure 5 (in fact the delay circuit 16 is not used) as its fundamental element and generates as its multiplied result the output of 2n − 1 bits expressed by two's complement signed binary numbers. That is, data without the most significant bit of the multiplier and multiplicand signals B and A formed of n bits expressed by two's complement signed binary numbers are respectively (n − 1) bits, so that data of A·B = (n − 1)·(n − 1) = 2n − 2 bits are generated. If the sign code is added to the nost significant bits of the calculation results, the final output data of (2n − 2 + 1) bits are provided. However, since a number of adder circuits forming the multiplier section 17 all require input data formed such that more significant bits are given a larger delay, the delay circuits 15 and 16 are not needed at every adder circuit in the digital signal processing circuit 1, but are only required at the input and output stages of the multiplier section 17. Moreover, since another adder section, which will be described later, is provided at a later stage, the delay circuit 16 is not required in practice at the output stage of the multiplier section 17. Therefore, it is sufficient that the multiplier section 17 generates data formed such that more significant bits are given a larger delay at intervals of, for example, two bits.

In Figure 1A, reference numeral 18 denotes a selector which receives the product signal A·B from the multiplier section 17, the signal formed of the multiplicand signal A and the multiplier signal B from the selectors 5 and 9, and the signal formed of the multiplicand signal A and the multiplier signal B from the delay circuit 12, and then selectively supplies one of those signals as designated by the select signal thereto.

The signal transmission path through the delay circuit 12 is provided to permit the multiplier section 17 to be by-passed, and the digital signal processing circuit 1 to operate as the adder. Thus, it serves to supply a signal having a predetermined delay to an adder circuit 22 which will be described later. The signal transmission path supplying the signals from the selectors 5 and 9 directly to the selector 18 is provided so that the signal formed with more significant bits and given a larger delay is added to the inputs A and B initially for the same purpose. In this case, the input to the digital signal processing circuit 1 has already passed through the delay circuits.

A delay circuit 19 delays equally each bit signal of a signal to be added or summand signal C of $2n - 1 + a$ bits by a unit delay amount. In other words, the delay circuit 19 functions as a latch circuit for each bit signal. Since the digital signal processing circuit 1 is connected in series in several stages as will be described later, this summand signal C comprises $2n - 1 + C$ bits including the word length a of the remainder bits (over-head bits) increased by the calculation during that process. The differences in the number of bits such as $2n - 1 + C$, $2n - 1$ and $2n$ are removed by the correction function of, for example, each selector and adder and then calculated. A delay circuit 20 delays the summand signal C in such a manner that more significant bits are given a larger unit delay amount at intervals of a plurality of bits, for example, every two or four bits. This delay circuit 20 is the same in construction as the delay circuit 12 with only the difference that the delay amount is increased by one step at each bit and the number of bits is different. The reason why the delay amount is increased by one step is that the delay circuit 20 itself has a latch function for data, and is then provided with a latch flip-flop of one step at, for example, the bit O line. A selector 21 receives the output signals of the delay circuits 19 and 20 and then selectively supplies one of those output signals as designated by a select signal. The signal path through the delay circuit 20 is to supply the summand signal C to the adder circuit 22, which will be described later, as a signal having a predetermined delay. Also, the signal path through the delay circuit 19 is to deal with the case where a signal in which more significant bits are given a larger delay is initially supplied thereto as the summand signal C.

An adder section 22 adds the output signal derived from the selector 18 to the summand signal C derived from the selector 21. As was already mentioned, the adder section 22 is constructed such that the calculation is performed at a time when more significant bits have a larger delay at intervals of a plurality of bits, for example, every two bits. A sum signal delay circuit 23 delays the sum signal from the adder section 22 in such a manner that each bit signal thereof is delayed by a unit delay amount. A delay circuit 24 delays the sum signal derived from the adder section 22 in such a manner that less significant bits thereof are given a larger delay. This delay circuit 24 delays the signal, which is supplied from the adder section 22 by a delay amount of, for example, two bits each time a unit delay time elapses in the order from less significant bits to more significant bits, in such a manner that a larger delay is given to less significant bits so that all the bit signals of the digital signal sampled originally at the same time before being supplied to the digital signal processing circuit 1 are generated at the same time. The delay circuit 24 corresponds to the delay circuit 16 shown in Figure 5 in which each bit signal is delayed by the delay amount increased by one step in the circuit shown in Figure 2B-b or occasionally in the circuit shown in Figure 2C-b by the bit number of the adding blocks of the multiplier section 17 and the adder section 22. As when the delay circuit 171 shown in Figure 2A-a is employed as the delay circuit 12, the delay circuit 172 shown in Figure 2A-b is employed as the delay circuit. Moreover, when the delay circuit 24 is given a latch function if necessary, the delay circuit 172 is provided with a delay amount of one extra step for each bit. In order words, it is necessary to provide one flip-flop stage for the O bit line.

A selector 25 receives the output signals from the sum signal delay circuit 23 and 24 and then supplies one output signal D of those output signals as designated by a select signal supplied thereto. The signal path through the sum signal delay circuit 23 is to allow the supply of the signal from the adder section 22, which is formed such that more significant bits are given a larger unit delay amount at intervals of, for example, every two bits. On the other hand, the signal path through the delay circuit 24 is to correct the different delay amounts of the signal dependent on the respective bits, and to generate the output signal D with the bits each having the same delay.

A digital signal processing circuit 1 as shown in Figure 1A is formed on a one-chip integrated circuit, and the functions thereof can be changed in response to the control contents by the select signals for the respective selectors 5, 9, 18, 21 and 25.

Figures 6A to 6D respectively show parts of circuits which can be realised by varying the select signals applied to the selectors 5, 9, 18, 21 and 25 in the digital signal processing circuit 1. Throughout the Figures, reference characters 1a to 1d denote circuits effectively realised in the respective stages or modes of the digital signal processing circuit 1.

The circuit 1a shown in Figure 6A is realised under the following condition, namely, in the state of the digital signal processing circuit 1 in which the selectors 5 and 9 supply the outputs of the delay circuits 2 and 6, the selector 18 supplies the output of the multiplier section 17, the selector 21 supplies the output of the delay circuit 20, and the selector 25 supplies the output of the delay circuit 24 and carries out the calculation of $A \cdot B + C$. However, if the delay circuit 20 is grounded at its input side thereby to make the summand signal C zero, the circuit 1a functions as the multiplier circuit which merely performs the multiplication $A \cdot B$.

The circuit 1b shown in Figure 6B is an adder circuit realised under the condition that the selectors 5 and 9 supply the outputs of the delay circuits 2 and 6, the selector 18 supplies the output of the delay circuit 12, the selector 21 supplies the output of the delay circuit 20 and the selector 25 transmits the output of the delay circuit 24. The adder circuit 1b adds the summand signal C to the signal AB (this does not mean the multiplication A × B) in which the more significant bits are represented by A and the less significant bits are represented by B. As set forth above, if the selectors 5, 9, 18, 21 and 25 are properly controlled by the respective select signals supplied thereto, the effective circuit arrangement of the digital signal processing circuit 1 can be changed. In this case, in the following description of the succeeding circuits 1c and 1d, the selected states of the selectors 5, 9, 18, 21 and 25 will for brevity not be described.

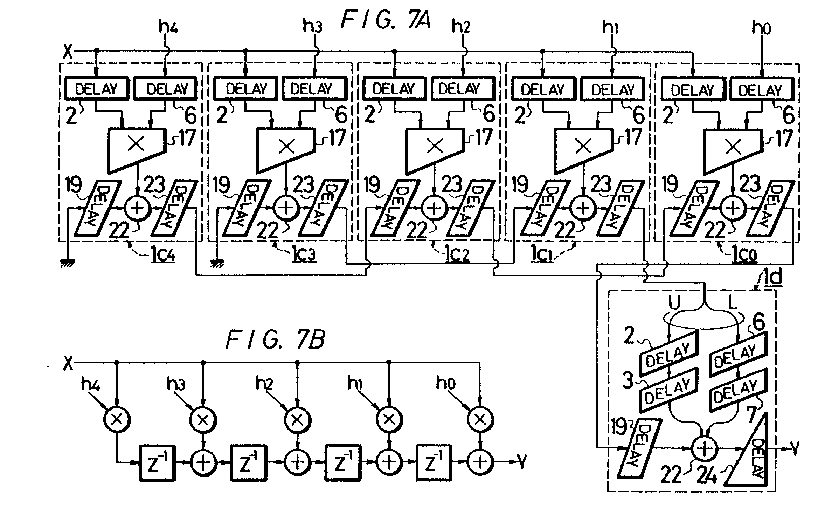

The circuit 1c shown in Figure 6C represents a multiplier-adder circuit MAC which forms a so-called finite impulse response (FIR) type-digital filter, and the circuit 1d shown in Figure 6D represents the adder circuit. Figure 7A shows an embodiment of the invention in the form of a 5-tap FIR-type digital filter formed of MAC circuits 1c4, 1c3, 1c2, 1c1 and 1c0 and the adder circuit 1d, and Figure 7B is an equivalent circuit thereof. To this FIR-type digital filter, more specifically, to the five MAC circuits 1c0, 1c1, 1c2, 1c3 and 1c4 forming it are applied an input signal X as the multiplicand signal A and further constant signals h4, h3, h2, h1 and h0 as the multiplier signal B. Furthermore, the input sides of the delay circuits 19 and 19 in the MAC circuits 1c4 and 1c3 which receive the constant signals h4 and h3 as the multiplier signal B are grounded thereby to make their summand signal C zero. Thus, the MAC circuits 1c4 and 1c3 merely function as the multiplier circuits which search for the results of multiplications h4·X and h3·X.

The output signal of the MAC circuit 1c4 is supplied to the MAC circuit 1c2, which receives the constant signal h2, as the summand signal C. The output signal D from this MAC circuit 1c2 is supplied to the MAC circuit 1c0, which receives the constant signal h0, as the summand signal C. The output signal D from the MAC circuit 1c3 is supplied to the MAC circuit 1c1, which receives the constant signal h1, as the summand signal C. The output signal from the MAC circuit 1c0 is supplied to the adder circuit 1d shown in Figure 6D as the summand signal C. The output signal from the MAC circuit 1c1 is supplied to the adder circuit 1d as the adding signal. Concerning the output signal from this MAC circuit 1c1, the more significant side signal U thereof is supplied to the delay circuit 2 as if it were the multiplicand signal A, while the less significant side signal L thereof is supplied to the delay circuit 6 as if it were the multiplier signal B. However, in this case, the signals A and B are not multiplied with each other because they are not passed through the multiplier section 17.

The 5-tap FIR-type digital filter circuit shown in Figure 7A is not formed of the MAC circuits 1c4, 1c3, 1c2, 1c1 and 1c0 connected in cascade but the circuit formed of the MAC circuits 1c4, 1c2 and 1c0 connected in cascade and the circuit formed of the MAC circuits 1c3 and 1c1 connected in cascade, wherein the output signals from the above two circuits are added together by the adder circuit 1d.

The reason for this will be described below. In each MAC circuit 1c, the adder section 22 is not only provided at its output side with the delay circuit 23 but also provided at its summand signal input side with the delay circuit 19. Then, if all the MAC circuits 1c4 to 1c0 are connected in cascade, each of the product signals h4·X, h3·X, h2·X, h1·X and h0·X is delayed by the extra unit delay amount each time the signal is passed through the one MAC circuit 1c as compared with those of the FIR-type digital filter shown in Figure 7B. Therefore, it is necessary to avoid the situation that a predetermined filter characteristic cannot be obtained. As to the output signals from the MAC circuits 1c0 and 1c1, as will be clear from the equivalent circuit shown in Figure 7B, since the latter output signal must be delayed more by the unit delay amount than the former output signal, in the adder circuit 1d, the output signal from the MAC circuit 1c0 is delayed by the unit delay amount by the delay circuit 19, while the output signal from the MAC circuit 1c1 is delayed by twice the unit delay amount by the delay circuits 2, 3, 6 and 7. Moreover, the adder section 22 for adding two output signals together generates a digital signal of $2n - 1 + a$ (a is a positive integer) bits in the sequential order of less significant bits to more significant bits. Then, if such a digital signal is delayed by the delay circuit 24 in such a manner that less significant bits are given a larger unit delay amount at, for example, intervals of two bits, all the bit signals of the digital signal originally sampled at the same sampling time can be generated simultaneously.

If the digital filter is constructed as described above, when $N + 1$ (N is a positive integer) digital signal processing circuit 1 are employed, N digital signal processing circuits 1 are put into the mode of the MAC circuit 1c as shown in Figure 6C and the remaining one digital signal processing circuit 1 is put into the mode of the adder circuit 1d as shown in Figure 6D, it is possible to provide an N-tap FIR-type digital filter as commonly used, for example, for video cameras.

Moreover, such digital filters can operate at relatively high speed. In addition, the number of delay elements required is relatively small.

**Claims**

1. A multi-stage digital filter comprising:
a plurality of stages including respective digital signal processing circuits each comprising a multiplier means (17) for multiplying signals of a plurality of bits by each other to produce a product signal; characterised by:
each of said digital signal processing circuits further comprising summand signal delay circuit means (19) for delaying each bit signal of a summand signal of a plurality of bits by a unit delay, adder means (22) for adding said product signal from said multiplier means (17) to the summand signal from said summand signal delay circuit means (19), and sum signal delay circuit means (23) for delaying each bit signal of the sum signal from said adder means (22) by a unit delay, said multiplier means (17), said summand signal delay circuit means (19), said adder means (22) and said sum signal delay circuit means (23) being formed in the same semiconductor chip;

odd-stage cascade circuit means formed of said digital signal processing circuits of odd stages being connected in cascade so that an output signal of a first-stage digital signal processing circuit (1c4) is supplied to a third-stage digital signal processing circuit (1c2) as said summand signal;

even-stage cascade circuit means formed of said digital signal processing circuits of even stages being connected in cascade so that an output signal of a second-stage digital signal processing circuit (1c3) is supplied to a fourth-stage digital signal processing circuit (1c1) as said summand signal;

adder means (22) for adding output signals from said odd-stage cascade circuit means (1c4, 1c2, 1c0) and said even-stage cascade circuit means (1c3, 1c1) together in such a manner that said output signal are given an equal delay; and

output circuit means (24) for delaying an output signal from said adder means (22) which adds the output signals from said even-stage and odd-stage cascade circuit means.

2. A digital filter according to claim 1 wherein said multiplier means (17) multiplies signals of a plurality of bits by each other to generate said product signal in which each more significant bit has a larger delay than the next less significant bit.

3. A digital filter according to claim 2 wherein said multiplier means (17) includes delay circuit means (171) which delays signals of a plurality of bits by a unit delay of one bit each.

4. A digital filter according to claim 1 wherein said multiplier means (17) multiplies signals of a plurality of bits by each other to generate said product signal in which more significant bits are given a larger delay, the amount of delay increasing at intervals of a plurality of bits.

5. A digital filter according to claim 4 wherein said multiplier means (17) includes delay circuit means (15) which delays a signal of a plurality of bits such that more significant bits are given larger delays, the amount of delay increasing every two or every four bits.

6. A digital filter according to claim 1 further comprising output sum signal delay circuit means (24) in said output circuit means (24) for delaying a sum signal, which has been delayed such that the more significant bits have larger unit delays, the delay increasing at intervals of a plurality of bits, in such a way as to give a larger unit delay to the less significant bits, the delay increasing at intervals of a plurality of bits so as to cancel the difference in delays between respective bits of said sum signal, said sum signal delay circuit means (23) delaying each bit of said sum signal from said adder means (22) by an equal delay amount, and selector means (25) for receiving output signals of said output sum signal and sum signal delay circuit means (24, 23) and supplying one of said output signals as designated by a select signal supplied thereto, said output sum signal delay circuit means (24) and said selector means (25) being formed in said semiconductor chip.

7. A digital filter according to claim 1 further comprising selector means (18) for receiving a signal formed of less significant bits corresponding to either of a multiplicand signal and a multiplier signal supplied to said multiplier means (17) and more significant bits corresponding to the other signal thereof and said product signal from said multiplier means (17), and supplying one of those signals designated by a select signal supplied thereto, said adder means (22) adding an output signal from said selector means (18) to said other summand signal of a plurality of bits, said selector means (18) being formed in said semiconductor chip.

8. A digital filter according to claim 1 further comprising delay circuit means (12) for receiving a signal formed of more significant bits corresponding to either of a multiplicand signal and a multiplier signal supplied to said multiplier means (17) and less significant bits corresponding to the other signal thereof and delaying said received signal in such a manner that more significant bits are given a larger unit delay, the delay increasing at intervals of a plurality of bits, and selector means (18) for receiving a signal the same as that received by said delay circuit means (12), an output signal from said delay circuit means (12) and said product signal which is an output signal from said multiplier means (17), and supplying one of those signals as designated by a select signal supplied thereto, said adder means (22) adding an output signal from said selector means (18) to another summand signal having a plurality of bits, said delay circuit means (12) and said selector means (18) being formed in said semiconductor chip.

9. A digital filter according to claim 1 further comprising variable delay circuit means (10') for delaying both of a multiplicand signal and a multiplier signal supplied to said multiplier means or an output signal from said multiplier means, said variable delay circuit means (10') being formed in said semiconductor chip.

10. A digital filter according to claim 1 further comprising delay circuit means (12) for receiving a signal formed of more significant bits corresponding to either of a multiplicand signal and a multiplier signal supplied to said multiplier means and less significant bits corresponding to the other signal thereof and delaying said received signal in such a manner that more significant bits are given a larger unit delay amount, the delay increasing at intervals of a plurality of bits, first selector means (18) for receiving a signal the same as that received by said delay circuit means, an output signal from said delay circuit means and a product signal which is an output signal from said multiplier means (17), and supplying one of those signals as designated by a select signal supplied thereto, first summand signal delay circuit means (20) for delaying a summand signal of a plurality of bits in such a manner that more significant bits are given a larger unit delay amount, the delay increasing at intervals of a plurality of bits, and second summand signal delay circuit means (19) for delaying all the bit signals of said summand signal by a unit delay amount, second selector means (21) for receiving output signals of said first and second summand signal delay circuit means and generating one of those signals as designated by a selector signal, and said adder means (22) for adding output signals from said first and second selector means (18, 21), said delay circuit means (12), said first selector means (18), said first summand signal delay circuit means (20), said second summand signal delay circuit means (19) and said second selector means (21) being formed in said semiconductor chip.

**Patentansprüche**

1. Mehrstufiges Digitalfilter mit mehreren Stufen, die jeweilige Digitalsignal-Verarbeitungsschaltungen enthalten, deren jede ein Multipliziermittel (17) zum Multiplizieren von aus mehreren Bits bestehenden Signalen miteinander zum Erzeugen eines Produktsignals aufweist, gekennzeichnet durch:

— jede der Digitalsignal-Verarbeitungsschaltungen weist ferner eine Summandsignal-Verzögerungsschaltung (19) zum Verzögern jedes Bitsignals eines aus mehreren Bits bestehenden Summandsignals um eine Einheitsverzögerung, ein Addiermittel (22) zum Addieren des Produktsignals von dem Multipliziermittel (17) zu dem Summandsignal von der Summandsignal-Verzögerungsschaltung (19) und eine Summensignal-Verzögerungsschaltung (23) zum Verzögern jedes Bitsignals des Summensignals von dem Addiermittel (22) um eine Einheitsverzögerung auf, wobei das Multipliziermittel (17), die Summandsignal-Verzögerungsschaltung (19), das Addiermittel (22) und die Summensignal-Verzögerungsschaltung (23) auf demselben Halbleiter-Chip ausgebildet sind,

— eine ungeradzahlige Kaskadenschaltung, die aus den Digitalsignal-Verarbeitungsschaltungen von ungeradzahligen Stufen besteht, sind in Kaskade geschaltet, so daß ein Ausgangssignal einer Digitalsignal-Verarbeitungsschaltung (1c4) in einer ersten Stufe einer Digitalsignal-Verarbeitungsschaltung (1c2) in einer dritten Stufe als das Summandsignal zugeführt ist,

— eine geradzahlige Kaskadenschaltung, die aus den Digitalsignal-Verarbeitungsschaltungen von geradzahligen Stufen besteht, sind in Kaskade geschaltet, so daß ein Ausgangssignal einer Digitalsignal-Verarbeitungs-Schaltung (1c3) in einer zweiten Stufe einer Digitalsignal-Verarbeitungsschaltung (1c1) in einer vierten Stufe als das Summandsignal zugeführt ist,

— ein Addiermittel (22) addiert die Ausgangssignale von der ungeradzahligen Kaskadenschaltung (1c4, 1c2, 1c0) und von der geradzahligen Kaskadenschaltung (1c3, 1c1) derart, daß die Ausgangssignale eine gleiche Verzögerung erfahren, und

— eine Ausgangsschaltung (24) verzögert ein Ausgangssignal von dem Addiermittel (22), das die Ausgangssignale von ungeradzahliger und geradzahliger Kaskadenschaltungen addiert.

2. Digitalfilter nach Anspruch 1, bei dem das Multipliziermittel (17) Signale aus mehreren Bits miteinander multipliziert, um das Produktsignal zu erzeugen, wobei jedes höherwertigere Bit eine größere Verzögerung als das nächst niederwertigere Bit aufweist.

3. Digitalfilter nach Anspruch 2, bei dem das Multipliziermittel (17) eine Verzögerungsanordnung (171) enthält, die Signale aus mehreren Bits um eine Einheitsverzögerung von jeweils einem Bit verzögert.

4. Digitalfilter nach Anspruch 1, bei dem das Multipliziermittel (17) Signale aus mehreren Bits miteinander multipliziert, um das Produktsignal zu erzeugen, wobei jedes höherwertigere Bit eine größere Verzögerung erfährt, wobei der Betrag der Verzögerung in Intervallen von mehreren Bits ansteigt.

5. Digitalfilter nach Anspruch 4, bei dem das Multipliziermittel (17) eine Verzögerungsschaltung (15) enthält, die ein Signal aus mehreren Bits derart verzögert, daß die höherwertigeren Bits eine größere Verzögerung erfahren, wobei sich der Betrag der Verzögerung jeweils alle zwei oder alle vier Bits erhöht.

6. Digitalfilter nach Anspruch 1, das desweiteren eine Ausgangssummensignal-Verzögerungsschaltung (24) in der Ausgangsschaltung (24) zum Verzögern eines Summensignals, das derart verzögert worden ist, daß die höherwertigeren Bits größere Einheitsverzögerungen aufweisen, wobei die Verzögerung in Intervallen von mehreren Bits ansteigt, derart, daß die niederwertigeren Bits eine größere Einheitsverzögerung erhalten, wobei die Verzögerung in Intervallen von mehreren Bits ansteigt, um die Differenz in den Verzögerungen zwischen jeweiligen Bits des Summensignals zu beseitigen, wobei die Summensignal-Verzögerungsschaltung (23) jedes Bit des Summensignals von dem Addiermittel (22) um einen gleichen Verzögerungsbetrag verzögert, und ein Auswahlmittel (25) enthält zum Empfangen der Ausgangssignale der Ausgangssummensignal- und der Summensignal-Verzögerungsschaltungen (24, 23) und Abgeben eines der Ausgangssignale, wie es durch ein ihm zugeführtes Auswahlsignal gekennzeichnet ist, wobei die Ausgangssummensignal-Verzögerungsschaltung (24) und das Auswahlmittel (25) in dem Halbleiter-Chip ausgebildet sind.

7. Digitalfilter nach Anspruch 1, das desweiteren ein Auswahlmittel (18) zum Empfangen eines Signals, das aus niederwertigeren Bits, die entweder einem Multiplikandsignal oder einem Multiplikatorsignal korrespondieren, die dem Multipliziermittel (17) zugeführt sind, und höherwertigeren Bits, die mit dem jeweils anderen Signal korrespondieren, gebildet ist, sowie des Produktsignals von dem Multipliziermittel (17) und zum Abgeben eines dieser Signale, das durch ein ihm zugeführten Auswahlsignal gekennzeichnet ist, enthält, wobei das Addiermittel (22) ein Ausgangssignal von dem Auswahlmittel (18) zu dem anderen Summandsignal aus mehreren Bits addiert und wobei das Auswahlmittel (18) in dem Halbleiter-Chip ausgebildet ist.

8. Digitalfilter nach Anspruch 1, das desweiteren eine Verzögerungsschaltung (12) zum Empfangen eines Signals, das aus höherwertigeren Bits, die entweder mit einem Multiplikandsignal oder einem Multiplikatorsignal korrespondieren, die dem Multipliziermittel (17) zugeführt sind, und aus niederwertigeren Bits, die mit dem jeweils anderen Signal korrespondieren, gebildet ist, und zum Verzögern des empfangenen Signals, derart, daß den höherwertigeren Bits eine größere Einheitsverzögerung zugeordnet ist, wobei die Verzögerung in Intervallen von mehreren Bits ansteigt, und ein Auswahlmittel (18) aufweist zum Empfangen eines Signals, das dasselbe wie dasjenige ist, welches von der Verzögerungsschaltung (12) empfangen ist, eines Ausgangssignals von der Verzögerungsschaltung (12) und des Produktsignals, welches ein Ausgangssignal von dem Multipliziermittel (17) ist, und zum Abgeben eines dieser Signale, wie er durch ein ihm zugeführtes Auswahlsignal gekennzeichnet ist, wobei das Addiermittel (22) ein Ausgangssignal von dem Auswahlmittel (18) zu einem anderen Summandsignal aus mehreren Bits addiert, wobei die Verzögerungsschaltung (12) und das Auswahlmittel (18) in dem Halbleiter-Chip ausgebildet sind.

9. Digitalfilter nach Anspruch 1, das desweiteren eine variable Verzögerungsschaltung (10') zum Verzögern sowohl eines Multiplikandsignals als auch eines Multiplikatorsignals, die dem Multipliziermittel zugeführt sind, oder eines Ausgangssignals von dem Multipliziermittel enthält, wobei die variable Verzögerungsschaltung (10') in dem Halbleiter-Chip ausgebildet ist.

10. Digitalfilter nach Anspruch 1, das desweiteren eine Verzögerungsschaltung (12) zum Empfangen eines Signals, welches aus höherwertigeren Bits, die mit einem Multiplikandsignal und einem Multiplikatorsignal korrespondieren, die dem Multipliziermittel zugeführt sind, und niederwertigeren Bits, die mit dem jeweils anderen Signal korrespondieren, gebildet ist, und zum Verzögern des empfangenen Signals, derart, daß den höherwertigeren Bits eine Einheitsverzögerung mit höherem Betrag zugeordnet ist, wobei die Verzögerung in Intervallen von mehreren Bits ansteigt, ein erstes Auswahlmittel (18) zum Empfangen eines Signals, das dasselbe wie desjenige ist, welches durch die Verzögerungsschaltung empfangen ist, eines Ausgangssignals von der Verzögerungsschaltung und eines Produktsignals, das ein Ausgangssignal von dem Multipliziermittel (17) ist, und zum Abgeben eines dieser Signale, wie es durch ein ihm zugeführtes Auswahlsignal gekennzeichnet ist, eine erste Summandsignal-Verzögerungsschaltung (20) zum Verzögern eines Summandsignals aus mehreren Bits, derart, daß höherwertigeren Bits eine Einheitsverzögerung mit größerem Betrag zugeordnet ist, wobei die Verzögerung in Intervallen von mehreren Bits ansteigt, eine zweite Summandsignal-Verzögerungsschaltung (19) zum Verzögern aller Bitsignale des Summandsignals um einen Einheitsverzögerungsbetrag und ein zweites Auswahlmittel (21) aufweist zum Empfangen von Ausgangssignalen von erster und zweiter Summandsignal-Verzögerungsschaltung und zum Abgeben eines dieser Signale, wie es durch ein Auswahlsignal gekennzeichnet ist, wobei das Addiermittel (22) Ausgangssignale von dem ersten und dem zweiten Auswahlmittel (18, 21) addiert und wobei die Verzögerungsschaltung (12), das erste Auswahlmittel (18), die erste Summandsignal-Verzögerungsschaltung (20), die zweite Summandsignal-Verzögerungsschaltung (19) und das zweite Auswahlmittel (21) in dem Halbleiter-Chip ausgebildet sind.

**Revendications**

1. Filtre numérique à plusieurs étages comprenant:

un ensemble d'étages incluant des circuits de traitement de signaux numériques respectifs comprenant chacun un moyen multiplicateur (17) pour multiplier des signaux d'un ensemble de bits entre eux pour produire un signal de produit; caractérisé en ce que:

chacun des circuits de traitement de signaux numériques comprend en outre un circuit à retard de signal d'opérande de somme (19) pour retarder chaque signal de bit d'un signal d'opérande de somme d'un ensemble de bits d'un retard unitaire, un moyen additionneur (22) pour additionner le signal de produit provenant du moyen multiplicateur (17) avec le signal d'opérande de somme provenant du circuit à retard de signal d'opérande de somme (19), et un circuit à retard de signal de somme (23) pour retarder chaque signal de bit du signal de somme provenant du moyen additionneur (22) d'un retard unitaire, le moyen multiplicateur (17), le circuit à retard de signal d'opérande de somme (19), le moyen additionneur (22) et le circuit à retard de signal de somme (23) étant formés dans la même puce à semiconducteur; et par:

un circuit d'étages impairs en cascade constitué des circuits de traitement de signaux numériques d'étages impairs connectés en cascade de sorte qu'un signal de sortie d'un circuit de traitement de signaux numériques de premier étage (1c4) est fourni à un circuit de traitement de signaux numériques de troisième étage (1c2) comme signal d'opérande de somme;

un circuit d'étages pairs en cascade constitué des circuits de traitement de signaux numériques d'étages pairs connectés en cascade de sorte qu'un signal de sortie d'un circuit de traitement de signaux numériques de deuxième étage (1c3) est fourni à un circuit de traitement de signaux numériques de quatrième étage (1c1) comme signal d'opérande de somme;

un moyen additionneur (22) pour additionner les signaux de sortie du circuit d'étages impairs en cascade (1c4, 1c2, 1c0) et du circuit d'étages pairs en cascade (1c3, 1c1) ensemble de telle manière que les signaux de sortie subissent un retard égal; et par

un circuit de sortie (24) pour retarder un signal de sortie du moyen additionneur (22) qui additionne les signaux de sortie des circuits d'étages pairs et d'étages impairs en cascade.

2. Filtre numérique selon la revendication 1, dans lequel le moyen multiplicateur (17) multiplie les signaux d'un ensemble de bits entre eux pour engendrer le signal de produit dans lequel chaque bit de poids fort a un plus grand retard que le bit de poids faible suivant.

3. Filtre numérique selon la revendication 2, dans lequel le moyen multiplicateur (17) comprend un circuit à retard (171) qui retarde les signaux d'un ensemble de bits d'un retard unitaire d'un bit chacun.

4. Filtre numérique selon la revendication 1, dans lequel le moyen multiplicateur (17) multiplie les signaux d'un ensemble de bits entre eux pour engendrer le signal de produit dans lequel les bits de poids fort subissent un plus grand retard, la grandeur du retard augmentant à intervalles d'un ensemble de bits.

5. Filtre numérique selon la revendication 4, dans lequel le moyen multiplicateur (17) comprend un circuit à retard (15) qui retarde un signal d'un ensemble de bits de sorte que les bits de poids fort subissent des retards plus grands, la quantité de retard augmentant tous les deux bits ou tous les quatre bits.

6. Filtre numérique selon la revendication 1, comprenant en outre un circuit à retard de signal de somme de sortie (24) contenu dans le circuit de sortie (24) pour retarder un signal de somme, qui a été retardé de telle sorte que les bits de poids fort ont de plus grands retards unitaires, le retard augmentant à intervalles d'un ensemble de bits, de manière à donner un retard unitaire plus grand aux bits de poids faible, le retard augmentant à intervalles d'un ensemble de bits de manière à supprimer la différence de retards entre les bits respectifs du signal de somme, le circuit à retard de signal de somme (23) retardant chaque bit du signal de somme provenant du moyen additionneur (22) d'un retard égal, et un moyen sélecteur (25) pour recevoir les signaux de sortie des circuits à retard de signal de somme de sortie et de signal de somme (23, 24) et fournir l'un des signaux de sortie comme il est indiqué par un signal de sélection qu'il reçoit, le circuit à retard de signal de somme de sortie (24) et le sélecteur (25) étant formés dans ladite puce à semiconducteur.

7. Filtre numérique selon la revendication 1, comprenant en outre un sélecteur (18) pour recevoir un signal constitué de bits de poids faible correspondant à l'un d'un signal de multiplicande et d'un signal de multiplicateur fournis au moyen multiplicateur (17) et de bits de poids fort correspondant à l'autre de ces signaux et le signal de produit provenant du moyen multiplicateur (17), et pour fournir l'un de ces signaux indiqué par un signal de sélection qu'il reçoit, le moyen additionneur (22) additionnant un signal de sortie du sélecteur (18) avec l'autre signal d'opérande de somme d'un ensemble de bits, ledit sélecteur (18) étant formé dans ladite puce à semiconducteur.

8. Filtre numérique selon la revendication 1, comprenant en outre un circuit à retard (12) pour recevoir un signal constitué de bits de poids fort correspondant à l'un d'un signal de multiplicande et d'un signal de multiplicateur fournis au moyen multiplicateur (17) et de bits de poids faible correspondant à l'autre de ces signaux et pour retarder le signal reçu de manière à ce que les bits de poids fort aient un retard unitaire plus grand, le retard augmentant à intervalles d'un ensemble de bits, et un sélecteur (18) pour recevoir un signal identique à celui reçu par le circuit à retard (12), un signal de sortie du circuit à retard (12) et le signal de produit qui est un signal de sortie du moyen multiplicateur (17), et pour fournir l'un de ces signaux comme il est indiqué par un signal de sélection qu'il reçoit, le moyen additionneur (22) additionnant un signal de sortie du sélecteur (18) avec un autre signal d'opérande de somme comportant un ensemble de bits, le circuit à retard (12) et le sélecteur (18) étant formés dans la puce à semiconducteur.

9. Filtre numérique selon la revendication 1, comprenant en outre un circuit à retard variable (10') pour retarder à la fois un signal de multiplicande et un signal de multiplicateur fournis au moyen multiplicateur ou un signal de sortie du moyen multiplicateur, le circuit à retard variable (10') étant formé dans la puce à semiconducteur.

10. Filtre numérique selon la revendication 1, comprenant en outre un circuit à retard (12) pour recevoir un signal constitué de bits de poids fort correspondant à l'un d'un signal de multiplicande et d'un signal de multiplicateur fournis au moyen multiplicateur et de bits de poids faible correspondant à l'autre de ces signaux et pour retarder le signal reçu de manière à ce que les bits de poids fort subissent un retard unitaire plus grand, le retard augmentant à intervalles d'un ensemble de bits, un premier sélecteur (18) pour recevoir un signal identique à celui reçu par le circuit à retard, un signal de sortie du circuit à retard et un signal de produit qui est un signal de sortie du moyen multiplicateur (17), et pour fournir l'un de ces signaux comme il est indiqué par une signal de sélection qu'il reçoit, un premier circuit à retard de signal d'opérande de somme (20) pour retarder un signal d'opérande de somme d'un ensemble de bits de manière à ce que les bits de poids fort subissent un retard unitaire plus grand, le retard augmentant à intervalles d'un ensemble de bits, et un second circuit à retard de signal d'opérande de somme (19) pour retarder tous les signaux de bits du signal d'opérande de somme d'un retard unitaire, un second sélecteur (21) pour recevoir les signaux de sortie des premier et second circuits à retard de signal d'opérande de somme et pour engendrer l'un de ces signaux comme il est indiqué par un signal de sélection, et le moyen additionneur (22) pour additionner les signaux de sortie des premier et second sélecteurs (18, 21), le circuit à retard (12), le premier sélecteur (18), le premier circuit à retard de signal d'opérande de somme (20), le second circuit à retard de signal d'opérande de somme (19) et le second sélecteur (21) étant formés dans la puce à semiconducteur.

F I G. 1A

F I G. 1B

F I G. 2A-a

BIT 7   BIT 6   BIT 5   BIT 4   BIT 3   BIT 2   BIT 1   BIT 0

F I G. 2A-b

BIT 7

BIT 6

BIT 5

BIT 4

BIT 3

BIT 2

BIT 1

BIT 0

## F I G. 2B-a

## F I G. 2B-b

## F I G. 2C-a

## F I G. 2C-b

F I G. 3 (PRIOR ART)

F I G. 4

FIG. 5

FIG. 6A

FIG. 6B

FIG. 6C

FIG. 6D

0 101 318

8

FIG. 7A

h4  h3  h2  h1  h0

X

DELAY DELAY | DELAY DELAY | DELAY DELAY | DELAY DELAY | DELAY DELAY

2  6  17  | 2  6  17 | 2  6  17 | 2  6  17 | 2  6  17

×  ×  ×  ×  ×

19  23  | 19  23 | 19  23 | 19  23 | 19  23

DELAY + DELAY | DELAY + DELAY | DELAY + DELAY | DELAY + DELAY | DELAY + DELAY

22  1c4 | 22  1c3 | 22  1c2 | 22  1c1 | 22  1c0

1d

U  L

2  6

DELAY  DELAY

3

DELAY  DELAY

7

19

DELAY

+  DELAY  Y

22  24

FIG. 7B

X

h4  h3  h2  h1  h0

×  ×  ×  ×  ×

$Z^{-1}$ + $Z^{-1}$ + $Z^{-1}$ + $Z^{-1}$ + → Y